# EUROPEAN PATENT APPLICATION

(11) **EP 1 521 359 A1**
(43) Date of publication of application: **06.04.2005**
(21) Application number: 03022322.6
(22) Date of filing: 04.10.2003
(51) Int. Cl.: H03F 1/02, H03F 1/56, H03F 1/32

(54) **Amplifier assembly with an adjustable performance**

(71) Applicant: Lucent Technologies Network Systems GmbH, 90411 Nürnberg (DE)
(72) Inventor: Eckl, Wolfgang Franz, Dr., 91080 Spardorf (DE); Fischer, Georg, Dr., 90419 Nürnberg (DE); Friedel, Bernd Georg, 91477 Markt Bibart (DE)
(74) Representative: Blumbach Zinngrebe

(57) **Abstract**

An object of the present invention is to suggest an approach for providing an amplifier performance which is adjustable in particular with regard to a usable frequency range or frequency band of operation but also with regard to at least one further certain criterion, such as gain, bandwidth, efficiency, output power capability and linearity even when then amplifier is assembled.

The invention proposes an amplifier assembly, in particular an RF-power amplifier assembly for use in mobile radio system, especially in an UMTS or GSM system, comprising at least one active amplifying device (1), with the input and/or with the output of said active amplifying device (1) being connected to at least one controllable reconfigurable circuit (2a,2b,2a',2b').

## Description

### Field of the invention

The invention relates to an amplifier assembly, in particular an RF-power amplifier assembly for use in a mobile radio system and to a method of adjusting the performance of such an amplifier assembly.

### Background of the invention

Traditional amplifiers, in particular traditional RF power amplifiers are operated with fixed input and output matching networks. These fixed matching networks narrow the usable frequency range of the active device of said amplifier. Additionally, fixed input and output matching networks determine the performance of the amplifier. Consequently, such an amplifier can only designed to operate in a certain frequency band with a certain performance. Accordingly in particular in case of using such an amplifier within a mobile radio telecommunication system, for example within a base station thereof, the certain frequency band is complying with for example a GSM 900 band or a DCS (Digital Cellular System) 1800 system and a certain performance is fixedly optimized for example for linearity for the use in a UMTS (Universal Mobile Telecommunication System) system or for efficiency in a GSM (Global System for Mobile communication) system.

Thus, due to the operation of amplifiers with fixed input and output matching networks an amplifier design, in particular power amplifier design, according to the state of the art usually results in a compromise between gain, bandwidth efficiency, output power, capability and linearity. The only design parameter that can be adjusted during operation is the DC bias condition of the active amplifying device, provided that an adjustable biasing circuitry is incorporated in the amplifier design. Changing the active device's bias condition results in a kind of fine tuning the design performance but it can never widen the usable frequency range of a power amplifier nor change the amplifier's performance for example from best efficiency to best linearity.

Furthermore, with concepts according or similar to the Doherty concept and/or the Chireix outphasing the optimization of only one performance parameter of the amplifier is focused, for example the efficiency for the Doherty Concept and the Chireix outphasing amplifier. These concepts however worsen other performance parameter like linearity and bandwidth and hence, do not allow any independent adjustment of optimization of different performance parameters of the (power) amplifier. Another significant drawback of these concepts is that all optimization of the performance has to be incorporated in the amplifier assembly design and therefore can not be changed or fine tuned after the amplifier has been built. Additionally these concepts can not account for device and production spread.

Accordingly, main disadvantages involved with the above discussed state of the art are: The fixed input and output matching networks and additional circuits necessary for the concepts like Doherty or Chireix can only be designed for a fixed center frequency and a certain, normally rather narrow bandwidth. By optimizing one performance parameter of the amplifier one normally has to sacrifice other ones. Restrictions in the RF-design of the fixed input and output matching networks and additional circuits necessary for concepts like Doherty or Chireix reduce the achievable performance enhancement or optimization of the amplifier. The optimization of the amplifier's performance for a certain criterion is to be incorporated into the design and can neither be changed to another nor fine tuned after the amplifier has been built or assembled. One has to focus on optimization of one performance parameter before the amplifier design starts.

### Summary of the invention

An object of the present invention is therefore to provide with regard to the above discussed state of the art a new and improved approach to avoid or at least ameliorate the above disadvantages and in particular to provide an amplifier performance which is adjustable in particular with regard to a usable frequency range or frequency band of operation but also with regard to at least one further certain criterion, such as gain, bandwidth, efficiency, output power capability and linearity even when then amplifier is assembled.

The inventive solution is surprisingly achieved by subject matter of the independent claims.

Advantageous and/or preferred embodiments or refinements are the subject matter of respective dependent claims.

Accordingly the invention proposes to provide an amplifier assembly, in particular an RF-power amplifier assembly for use in a mobile radio system, especially in an UMTS or GSM system, preferably a CDMA (Code Division Multiple Access) system, with at least one active amplifying device at the input of which and/or at the output of which at least one controllable reconfigurable circuit is connected.

Preferably the control of the at least on reconfigurable circuit is performed in response to an selectable operating condition by means of at least one Look-Up table and/or by means of at least one sensor arranged to and/or connected with the active amplifier device and/or the reconfigurable circuit for detecting at least one amplifier performance related parameter. Advantageously, by the use of the at least one sensor the inventive amplifier assembly can be easily constituted as an adaptive system, if a control device is controlling the reconfigurable circuit in response to the detected parameter.

According to very preferred embodiments RF-MEMS switches and/or varactors or other similar techniques are used to design the preferably software controllable reconfigurable circuits to provide a further enhanced flexible design.

Accordingly, at a first glance of the invention the at least one reconfigurable circuits can be used to broaden the useable frequency range of the active device, thereby paving the way for broadband and/or multiband operation of the (power) amplifier assembly and at a second glance of the invention the reconfigurable circuit at the input and/or output of the active device can also be used to optimize the amplifier's performance in assembled condition for at least one further certain criterion, in particular gain, bandwidth, efficiency, output power capability or linearity, wherein the optimization of the at least one further certain criterion is preferably done in a kind of fine tuning after the reconfigurable circuit is adjusted to make the power amplifier assembly operate in a certain frequency range.

The invention is exemplary described in more detail and with regard to preferred embodiments hereinafter and by referencing the attached drawings.

### Brief description of the drawings

It is shown in:
Fig. 1: a schematic block diagram of a first embodiment of an inventive reconfigurable matching structure of a power amplifier assembly with multiple operation conditions and
Fig. 2: a schematic block diagram of a second preferred embodiment showing an adaptive system structure of an adjustable power amplifier assembly, where the matching is adaptively optimized.

### Detailed description of preferred embodiments

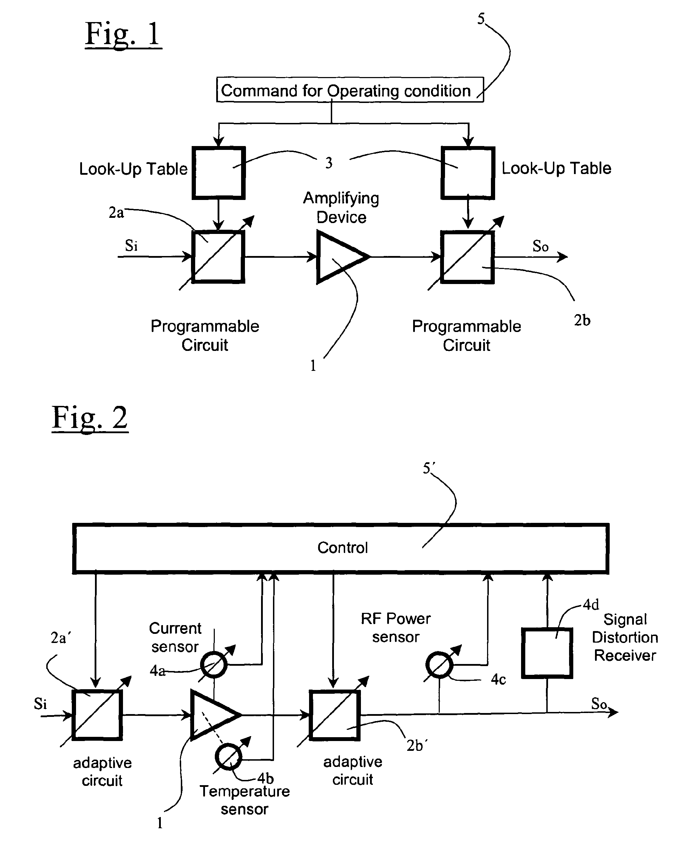

Fig. 1 is showing a first embodiment of the invention. As can be seen, two reconfigurable circuits 2a, 2b referred to in Fig. 1 as programmable circuits are arranged around an active amplifying device 1 of a power amplifier assembly at the input and at the output thereof. With each of the reconfigurable circuits 2a, 2b comprising for example variable impedance transformers, a Look-Up table is connected for controlling the circuits in response to respective commands for operating condition with regard to a selected or necessary amplifying rate between the input signal Sᵢ and the amplified output signal Sₒ. The commands for operating condition are preferably produced remotely by a control device 5 which is designed to transmit corresponding control signals to the look-up tables 3 assigned to the amplifier assembly, in particular in case the amplifier assembly is incorporated for example in a base station of a mobile radio telecommunication system based for example on a GSM or UMTS and/or CDMA standard.

According to the embodiment of Fig. 1, merely for the pure optimization purposes no additional hardware is necessary as the reconfigurable circuits 2a and 2b used for widening the useable frequency range can also be used for optimization of the amplifier performance for at least one further certain criterion, such as gain, bandwidth, center frequency/frequency band, efficiency, output power capability, linearity and/or signal distortion, the latter of which measured for example in terms of ACPR (Adjacent Channel Power Ratio), EVM (Error Vector Magnitude) or PCDE (Peak Code Domain Error). The reconfigurable circuits 2a and 2b preferably comprises an interface for providing an adjusting functionality in an electronic way. Accordingly the amplifier's performance can be changed or optimized even via corresponding software implemented within the look-up tables 3 and/or the control device after the amplifier assembly has been built and no hardware change is necessary.

Also the embodiment according to Fig. 2 has two reconfigurable circuits 2a' and 2b' around an active amplifying device 1 either at the input and the output thereof. Moreover, a plurality of different sensors 4a to 4d are arranged such to detected certain amplifying performance related parameter. As can be seen from Fig. 2, a current sensor 4a and a temperature sensor 4b are connected with the active device 1 and an RF-power sensor 4c and a signal distortion sensor or receiver 4d are connected with the reconfigurable circuit 2b' at the output of the active device 1 via the path of the amplified output signal Sₒ. The parameter information is then transferred to a control device 5' adjusting the reconfigurable circuits 2a'and 2b' in response thereof. Accordingly by such a control loop, the circuits 2a and 2b are adaptive even with regard to changing surrounding influences thereby entirely constituting an adaptive amplifier system.

Accordingly in the case of constituting such or a similar adaptive system additional hardware in form of specific sensors is proposed to be integrated.

However, with such or similar adaptive approach even drift phenomena, based for example on aging or temperature, in the amplifier's performance can be overcome and component tolerances restricting the achievable improvement in the amplifier's performance can be easily compensated for with an adaptive system according to Fig. 2.

Accordingly, with the embodiments according to Fig. 1 or Fig. 2 the amplifier's performance can be changed or optimized preferably via software after the amplifier has been built.

In contrast to fixed input and output matching networks leading to many compromises in the RF-design and achievable performance of the power amplifier with the inventive reconfigurable circuits a very increased flexibility is achieved and hence, not so many compromises in the RF-design and performance of the amplifier as with fixed circuits or other concepts like Doherty or Chireix are necessary.

Accordingly in future, cellular networks can be provided easily with necessary power amplifiers with much wider usable bandwidth and/or multiband capability, wherein multiband capability means that the same amplifier is enabled to operate in different frequency bands. In particular in this regard the use of the inventive reconfigurable circuits 2a, 2b, 2a'and 2b' around the active device 1 of the power amplifier is advantageous as fixed circuits lead to a narrow usable frequency range with the center frequency fixed. As a consequence a main task of those inventive amplifier assemblies is seen in the impedance transformation. However, as stated above the inventive amplifier assemblies can at the same time fulfill various additional tasks.

According to very preferred refinements the reconfigurable circuits are realized by the utilization of RF-MEMS (Radio Frequency Micro Electro-Mechanical Systems) switches and/or varactors or other similar techniques influencing RF characteristics. Therefore, to avoid the need of any manual action, for example the opening of the amplifier housing or the manually retuning of trimmers, the reconfigurable circuits are proposed to be adjustable in an electronic way via software to allow reconfiguration.

As a result, by using such kinds of reconfigurable circuits at the input and/or the output of the power amplifier's active device as depicted in Fig. 1 or Fig. 2 not only the usable frequency range can be widened or the frequency band of operation (center frequency) can be changed but the power amplifier's performance for certain criteria additionally can be optimized in particular for the use of the same inventive amplifying arrangement selectively in a UMTS system or in a GSM system.

## Claims

1. Amplifier assembly, in particular an RF-power amplifier assembly for use in mobile radio system, especially in an UMTS or GSM system, preferably a CDMA system, comprising at least one active amplifying device (1), with the input and/or with the output of said active amplifying device (1) being connected to at least one controllable reconfigurable circuit (2a, 2b, 2a', 2b').

2. Amplifier assembly according to claim 1, further **characterized in that** the at least one reconfigurable circuit (2a, 2b, 2a' , 2b') comprises an interface enabling reconfiguration in an electronic way, in particular by means of software.

3. Amplifier assembly according to any of the preceding claims, further **characterized by** an associated control device (5, 5') including software elements for controlling the at least one reconfigurable circuit (2a, 2b, 2a', 2b') to change, adapt and/or optimize the performance of the amplifier.

4. Amplifier assembly according to claim 1, 2 or 3, further **characterized in that** the at least one reconfigurable circuit (2a, 2b) is controllable by means of a look up table (3).

5. Amplifier assembly according to any of the preceding claims, further **characterized in that** the at least one reconfigurable circuit (2a, 2b) is reconfigurable by means of a look up table (3) in response to an operating condition command signal received from a control device (5).

6. Amplifier assembly according to claim 1, 2 or 3, further **characterized by** at least one sensor (4a, 4b, 4c, 4d) arranged to and/or connected with the active amplifying device (1) and/or the reconfigurable circuit (2a', 2b') for detecting at least one amplifier performance related parameter.

7. Amplifier assembly according to the preceding claim, further **characterized in that** the at least one reconfigurable circuit (2a', 2b') is reconfigurable by a control device (5') coupled with the output of the at least one sensor (4a, 4b, 4c, 4d) for controlling the reconfigurable circuit in response to the at least one detected parameter.

8. Amplifier assembly according to claim 6 or 7, further **characterized by** a plurality of sensors (4a, 4b, 4c, 4d), especially for detecting a power related, a current related, a temperature related and/or a signal distortion related parameter.

9. Amplifier assembly according to any of the preceding claims, further **characterized in that** the at least reconfigurable circuit (2a, 2b, 2a' , 2b') comprises at least one RF-characteristics influencing element, in particular based on MEMS-technology.

10. Amplifier assembly according to any of the preceding claims, further **characterized in that** the at least reconfigurable circuit (2a, 2b, 2a', 2b') comprises at least one RF-MEMS switch and/or varactor.

11. Base station for a mobile radio system, especially for an UMTS or GSM system, preferably a CDMA system, comprising an amplifier assembly, in particular an RF-power amplifier assembly, with at least one active amplifying device (1) with at least one controllable reconfigurable circuit (2a, 2b, 2a' , 2b') connected with the input and/or with the output of said active amplifying device (1).

12. Method of adjusting the performance of an amplifier assembly, in particular of an RF-power amplifier assembly for use in mobile radio system, especially in an UMTS or GSM system, comprising the steps of providing a connection of at least one controllable reconfigurable circuit (2a, 2b, 2a', 2b') with the input and/or with the output of at least one active amplifying device (1) used within the amplifier assembly, and of controlling the reconfigurable circuit in response to a selectable operating condition by means of at least one look up table (3) and/or in response to at least one detected parameter relating to amplifying performance.

13. Method according to the preceding claim, further comprising the step of controlling the at least one reconfigurable circuit (2a, 2b, 2a', 2b') to change, adapt and/or optimize the performance of the amplifier assembly.

14. Method according to any of the preceding claims, further comprising the step of controlling the at least one reconfigurable circuit (2a, 2b, 2a', 2b') in an electronic way, in particular by means of software.

15. Method according to the any of the preceding claims, further comprising the step of controlling the at least one reconfigurable circuit (2a, 2b, 2a' , 2b') for broadening the usable frequency range and the subsequent step of optimizing the amplifier's performance for at least one further certain criterion, in particular gain, bandwidth, efficiency, output power capability, linearity or signal distortion.

16. Use of a reconfigurable circuit for controlling the performance of an amplifier assembly, in particular of an RF-power amplifier assembly for use in mobile radio system, especially in an UMTS or GSM system.
